# FASCICULE DE BREVET EUROPEEN

(11) **EP 2 630 182 B1**
(45) Date de publication et mention de la délivrance du brevet: **25.02.2015**
(21) Numéro de dépôt: 11787919.7
(22) Date de dépôt: 18.10.2011
(51) Int. Cl.: C08G 81/02, C08L 53/00, C08K 3/00, C08K 3/32, C09K 21/12, H01L 31/048, H01L 31/0203

(54) **COMPOSITIONS THERMOPLASTIQUES TRANSPARENTES A HAUTE TENUE THERMOMECANIQUE ET IGNIFUGÉES SANS HALOGÈNE, EN PARTICULIER POUR L'ENCAPSULATION DANS LES MODULES PHOTOVOLTAÏQUES**
HALOGENFREIE, FEUERFESTE, TRANSPARENTE THERMOPLASTISCHE ZUSAMMENSETZUNGEN MIT HOHER THERMOMECHANISCHER FESTIGKEIT, IM BESONDEREN ZUR VERKAPSELUNG VON PV-MODULEN
HALOGEN-FREE, FIREPROOF, TRANSPARENT THERMOPLASTIC COMPOSITIONS HAVING HIGH THERMOMECHANICAL STRENGTH, IN PARTICULAR FOR ENCAPSULATION IN PHOTOVOLTAIC MODULES

(30) Priorité: 22.10.2010 FR 1058639
(43) Date de publication de la demande: 28.08.2013
(73) Titulaire: Arkema France, 92700 Colombes (FR)
(72) Inventeur: JOUSSET, Dominique, F-27471 Serquigny (FR); FLAT, Jean-Jacques, F-27170 Goupillieres (FR); GEORLETTE, Pierre, 84965 Omer (IL)
(74) Mandataire: Gavin, Pablo
(86) Numéro de dépôt international: PCT/FR2011/052430
(87) Numéro de publication internationale: WO 2012/052677

(56) Documents cités:
- EP-A2- 0 245 207
- FR-A1- 2 912 150
- FR-A1- 2 930 556
- US-A- 3 976 720

## Description

### Domaine de l'invention

L'invention a pour objet des compositions thermoplastiques transparentes ignifuges à haute tenue mécanique et thermomécanique, à base de polyoléfines fonctionnalisées greffées par des motifs polyamides contenant au moins des sels métalliques de l'acide phosphonique, et ne contenant pas de composés halogénés, ni de plastifiant phosphoré ou de phosphore rouge. La présente invention concerne également l'utilisation de cette composition dans un encapsulant ou encapsulant-backsheet d'un module photovoltaïque ainsi que le module photovoltaïque comprenant un tel encapsulant.

Le réchauffement climatique, lié aux gaz à effet de serre dégagés par les énergies fossiles, a mené au développement de solutions énergétiques alternatives qui n'émettent pas de tels gaz lors de leur fonctionnement, comme par exemple les modules photovoltaïques. Un module photovoltaïque comprend une « pile photovoltaïque », cette pile étant capable de transformer l'énergie lumineuse en électricité.

Il existe de nombreux types de structures de panneaux photovoltaïques.

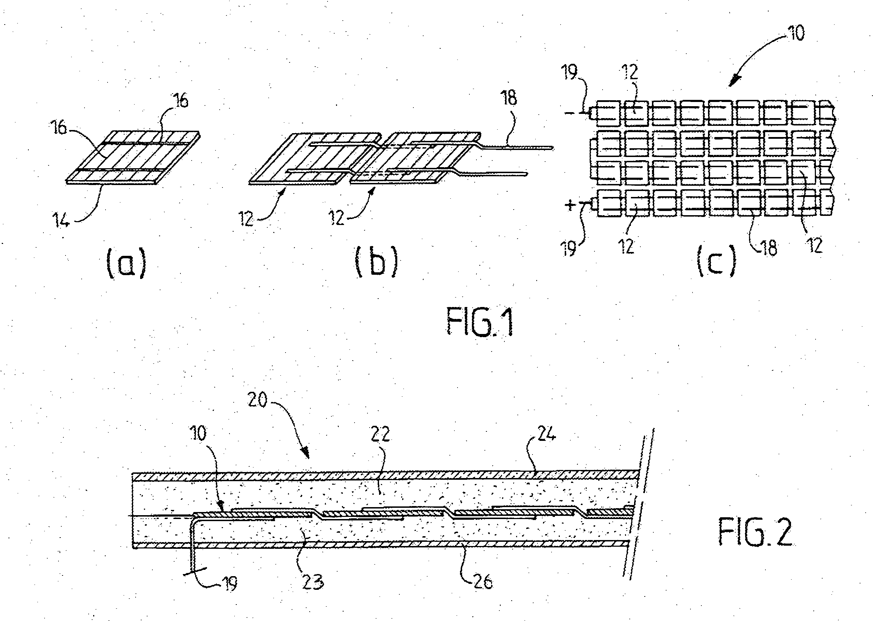

Sur la Figure 1, on a représenté une pile photovoltaïque classique ; cette pile photovoltaïque 10 comprend des cellules 12, une cellule contenant un capteur photovoltaïque 14, généralement à base de silicium traité afin d'obtenir des propriétés photoélectriques, en contact avec des collecteurs d'électrons 16 placés au-dessus (collecteurs supérieurs) et au-dessous (collecteurs inférieurs) du capteur photovoltaïque. Les collecteurs 16 supérieurs d'une cellule sont reliés aux collecteurs 16 inférieurs d'une autre cellule 12 par des barres conductrices 18, constituées généralement d'un alliage de métaux. Toutes ces cellules 12 sont connectées entre elles, en série et/ou en parallèle, pour former la pile photovoltaïque 10. Lorsque la pile photovoltaïque 10 est placée sous une source lumineuse, elle délivre un courant électrique continu, qui peut être récupéré aux bornes 19 de la pile 10.

En référence à la Figure 2, le module photovoltaïque 20 comprend la pile photovoltaïque 10 de la Figure 1 enrobée dans un « encapsulant », celui-ci étant composé d'une partie supérieure 22 et d'une partie inférieure 23. Une couche protectrice supérieure 24 (connue en anglais sous le terme « frontsheet », utilisé dans la suite) et une couche protectrice au dos du module (connue en anglais sous le terme « backsheet », également utilisé dans la suite) 26 sont disposées de part et d'autre de la pile encapsulée.

La protection au choc et à l'humidité de la pile photovoltaïque 10 est assurée par la couche protectrice supérieure 24, généralement en verre.

Le backsheet 26, par exemple un film multicouche à base de polymère fluoré et de polyéthylène téréphtalate, contribue à la protection à l'humidité du module photovoltaïque 20 et à l'isolation électrique des cellules 12 pour éviter tout contact avec l'environnement extérieur.

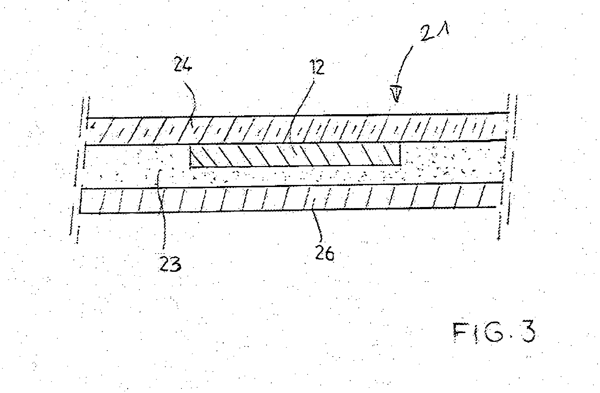

L'encapsulant 22 et 23 doit épouser parfaitement la forme de l'espace existant entre la pile photovoltaïque 10 et les couches protectrices 24 et 26 afin d'éviter la présence d'air, ce qui limiterait le rendement du module photovoltaïque. L'encapsulant 22 et 23 doit également empêcher le contact des cellules 12 avec l'eau et l'oxygène de l'air, afin d'en limiter la corrosion. La partie supérieure 22 de l'encapsulant est comprise entre la pile 10 et la couche protectrice supérieure 24. La partie inférieure 23 de l'encapsulant est comprise entre la pile 10 et le backsheet 26. Dans une variante de réalisation de l'encapsulant, il n'existe pas de partie inférieure ou supérieure de sorte que les cellules 12 de la pile se trouvent en contact avec respectivement le backsheet 26 ou le frontsheet 24. Cette variante est illustrée sur la figure 3 où l'on voit la cellule photovoltaïque 12 en contact direct avec le frontsheet 24 et est décrite plus en détails notamment dans la demande WO99/04971.

En présence de rayonnement solaire, il se crée un échauffement à l'intérieur du module solaire et des températures de 70°C (ou plus) peuvent être atteintes. Les propriétés thermomécaniques, et en particulier la tenue au fluage de l'adhésif, du liant ou de l'encapsulant doivent donc être conservées à ces températures pour que celui-ci ne soit pas déformé. La tenue au fluage est plus particulièrement importante dans le cas de l'encapsulant : en effet, en cas de fluage, la pile peut rentrer en contact avec l'air et/ou les couches protectrices supérieure et/ou inférieure, ce qui entraîne une diminution du rendement du module solaire, voire une dégradation de la pile et du module solaire.

Pour garantir une bonne durabilité du module solaire, l'encapsulant comme les couches de protection doivent présenter une bonne stabilité en présence d'humidité et des propriétés barrière vis-à vis de l'humidité suffisantes.

De plus, pour ne pas diminuer le rendement du module solaire, il est nécessaire que l'encapsulant permette la transmission des ondes lumineuses du rayonnement solaire vers les cellules. Toujours pour ne pas diminuer le rendement, il est nécessaire que ces ondes lumineuses soient peu diffractées, c'est-à-dire que l'encapsulant doit être, à l'oeil nu, transparent ou légèrement translucide, la transparence étant quantifiée par son « niveau de trouble » ou encore « Haze », qui doit être faible. Il est nécessaire également que l'encapsulant ait de bonnes propriétés d'isolation électrique, afin d'éviter tout court-circuit à l'intérieur du module photovoltaïque.

Ainsi, dans les applications d'encapsulant ou d'encapsulant-backsheet pour les modules photovoltaïques, les matériaux ou compositions doivent impérativement présenter une parfaite transparence afin d'autoriser la transmission sans perte (ou à minima) du rayonnement lumineux. Par ailleurs, ce matériau/composition thermoplastique doit présenter une bonne tenue mécanique, en particulier vis-à-vis des propriétés d'allongement à la rupture et à la contrainte à la rupture, ainsi que de bonnes propriétés thermomécaniques, en particulier vis-à-vis du test de fluage à chaud, compte tenu de l'échauffement du module photovoltaïque lors d'une exposition prolongée au soleil. Enfin, ce matériau/composition thermoplastique doit également présenter un bon niveau de résistance au feu (ignifugation) dans le cas des modules photovoltaïques intégrés aux bâtiments (ou « Building Integrated PV modules »).

A l'heure actuelle, il n'existe pas sur le marché de compositions thermoplastiques, en particulier pour les encapsulants de modules photovoltaïques, présentant des propriétés satisfaisantes au niveau de ces diverses exigences que sont en premier lieu la transparence (avec une nécessité de rester transparent dans le temps), puis une bonne tenue mécanique et thermomécanique ainsi qu'une bonne résistance au feu.

### Etat de l'art

De manière générale, l'Homme de l'Art sait que l'amélioration des propriétés ignifuges d'une composition thermoplastique se fait en général au détriment de ses propriétés mécaniques et thermomécaniques. Par ailleurs, dans le domaine des compositions/matériaux thermoplastiques, il est connu et pratiqué d'ajouter aux dits compositions/matériaux des charges minérales ignifuges (Aluminium Tri Hydroxyde, Magnésium Di Hydroxyde, Poly Phosphate d'ammonium, Cyanurate de Mélamine, sels métalliques de l'acide phosphinique, phosphore rouge, additifs bromés etc.) mais ces ajouts entraînent forcément un aspect opaque.

Seuls à ce jour des compositions thermoplastiques et transparentes sont connues à condition d'utiliser des plastifiants (liquides ou solides à température ambiante), par exemple à base de groupes phosphates ou chlorés/bromés. Or, ces plastifiants, espèces de bas poids moléculaires, sont connus pour donner, à terme ou dans des conditions de vieillissements thermiques, des soucis de migration en surface (phénomène de « blooming ») et de volatilité, donc de pertes de performance d'usage au cours du temps, tant d'un point de vue des performances mécaniques/thermomécaniques que d'un point de vue de la transmission de la lumière.

On connaît ainsi le document US 4972011 qui décrit une composition thermoplastique ignifugée sans halogène constitué de Polyamide (ou de copolymères à blocs de type Poly-Ether-bloc-amide (PEBA)) comportant des sels de l'acide phosphonique. On connaît également le document US 2006/0138391 qui décrit une composition thermoplastique ignifugée sans halogène constituée d'un polyamide éventuellement modifié choc (mélanges de polyamide et de caoutchoucs fonctionnels) comportant des sels de l'acide phosphonique et des additifs azotés.

On connaît enfin le document EP 0245207 qui fait mention du fait que les sels métalliques de l'acide phosphonique peuvent être utilisés comme agent ignifugeant.

Ces compositions ne sont pas présentées comme transparentes et si tant est qu'une variété thermoplastique particulière décrite dans ces documents le soit, il est connu que les PA modifiés choc donnent des matériaux opaques dans la mesure où la dispersion des nodules de caoutchouc fonctionnels possède des tailles toujours supérieures à 100 nm, conduisant immanquablement à la diffraction des rayons lumineux et donc à des matériaux opaques. Par ailleurs, leurs qualités mécaniques et thermomécaniques sont particulièrement faibles et certainement pas suffisantes pour des applications de haute technologie et à durée de vie élevée, telles que certaines applications pour des modules photovoltaïques.

### Brève description de l'invention

Il a été constaté par la demanderesse, après diverses expériences et manipulations, qu'une composition thermoplastique sans halogène remplit l'ensemble des propriétés nécessaires notamment à des applications de haute technologie dans le domaine photovoltaïque, à savoir un degré de transparence optimum et une conservation de ces propriétés optiques dans le temps y compris confronté à des conditions d'environnements sévères, des propriétés mécaniques et thermomécaniques excellentes ainsi que le classement de cette composition en tant que matériau ignifuge selon le classement UL94.

Ainsi, la présente invention concerne une composition thermoplastique ignifugée et transparente ne contenant pas de composé halogéné, comprenant un copolymère greffé à blocs polyamides constitué d'un tronc en polyoléfine et d'en moyenne au moins un greffon en polyamide dans lequel les greffons sont attachés au tronc par les restes d'un monomère insaturé fonctionnel (X) ayant une fonction capable de réagir avec un polyamide, les restes du monomère insaturé (X) sont fixés sur le tronc par greffage ou copolymérisation depuis sa double liaison, ledit polymère greffé polyamide présentant une organisation structurée à l'échelle nanométrique, caractérisée en ce qu'elle comprend, en pourcentage massique de la composition totale :
- entre 90% et 99% en poids du copolymère greffé à blocs polyamides,
- entre 1% et 10% en poids en sel métallique de l'acide phosphonique. Avantageusement, la composition thermoplastique de l'invention comprend :
   - entre 94% et 97% en poids du copolymère greffé à blocs polyamides,
   - entre 3% et 6% en poids en sels métalliques de l'acide phosphonique.

Selon une particularité de l'invention, le copolymère greffé à blocs polyamide comprend de 10% à 50% en masse de greffons en polyamide.

Selon une particularité de l'invention, la masse molaire des greffons polyamide est comprise dans la gamme allant de 1000 à 5000g/mol, de préférence comprise dans la gamme allant de 2000 à 3000 g.mol⁻¹. De plus, le nombre de monomère (X) fixé sur le tronc polyoléfine est supérieur ou égal à 1,3 et/ou inférieur ou égal à 10.

Selon un mode de réalisation préféré de l'invention, le monomère insaturé (X) est choisi parmi un anhydride d'acide carboxylique et un époxyde insaturé.

Selon un mode de réalisation de l'invention, la composition thermoplastique comprend uniquement le copolymère greffé à blocs polyamides et un sel métallique de l'acide phosphonique.

Selon une variante, la composition thermoplastique de l'invention comprend au moins un agent de couplage afin d'améliorer le pouvoir d'adhérence de la composition sur les substrats de la cellule photovoltaïque lorsque celui-ci doit être particulièrement élevé.

La composition peut comprendre en outre au moins un des composants additionnels choisis parmi les agents réticulant, les absorbants UV, les charges minérales, les plastifiants, les composés colorants ou azurants.

La présente invention concerne également l'utilisation de cette composition thermoplastique en tant que film encapsulant pour un module photovoltaïque.

Enfin, l'invention se rapporte aussi à un module photovoltaïque présentant au moins deux films dont un film formant encapsulant comportant une pile photovoltaïque apte à générer de l'énergie électrique, ce film étant formé par la susdite composition thermoplastique.

### Description des Figures annexées

La description qui va suivre est donnée uniquement à titre illustratif et non limitatif en référence aux figures annexées, dans lesquelles :
La Figure 1, déjà décrite, représente un exemple de pile photovoltaïque, les parties (a) et (b) étant des vues de ¾, la partie (a) montrant une cellule avant connexion et la partie (b) une vue après connexion de 2 cellules ; la partie (c) est une vue de dessus d'une pile photovoltaïque complète.
La Figure 2, déjà décrite, représente une coupe transversale d'un module photovoltaïque, dont le capteur photovoltaïque « classique » est encapsulé par un film d'encapsulant supérieur et un film d'encapsulant inférieur.
La Figure 3, déjà décrite, représente une coupe transversale d'un module photovoltaïque, dont le capteur photovoltaïque de type « couche mince » déposé sur la couche de protection supérieure est encapsulé avec un film d'encapsulant inférieur.

### Description détaillée de l'invention

S'agissant du tronc polyoléfine, c'est un polymère comprenant comme monomère une α-oléfine.

On préfère les α-oléfines ayant de 2 à 30 atomes de carbone.

A titre d' α-oléfine, on peut citer l'éthylène, le propylène, 1-butène, 1-pentène, 3-méthyl-1-butène, 1-hexène, 4-méthyl-1-pentène, 3-méthyl-1-pentène, 1-octène, 1-décène, 1-dodécène, 1-tétradécène, 1-hexadécène, 1-octadécène, 1-eicocène, 1-dococène, 1-tétracocène, 1-hexacocène, 1-octacocène, et 1-triacontène. Dans le cadre de la présente invention, le terme d'α-oléfine comprend également le styrène. On préfère le propylène et tout spécialement l'éthylène comme α-oléfine.

Cette polyoléfine peut-être un homopolymère lorsqu'une seule α-oléfine est polymérisée dans la chaîne polymère. On peut citer comme exemples le polyéthylène (PE) ou le polypropylène (PP).

Cette polyoléfine peut aussi être un copolymère lorsqu'au moins deux comonomères sont copolymérisés dans la chaîne polymère, l'un des deux comonomères dit le « premier comonomère » étant une α-oléfine et l'autre comonomère, dit « deuxième comonomère », est un monomère capable de polymériser avec le premier monomère.

A titre de deuxième comonomère, on peut citer :
- une des α-oléfines déjà citées, celle-ci étant différente du premier comonomère α-oléfine,
- les diènes tels que par exemple le 1,4-hexadiène, l'éthylidène norbornène, le butadiène
- les esters d'acides carboxyliques insaturés tels que par exemple les acrylates d'alkyle ou les méthacrylates d'alkyle regroupés sous le terme (méth)acrylates d'alkyles. Les chaînes alkyles de ces (méth)acrylates peuvent avoir jusqu'à 30 atomes de carbone. On peut citer comme chaînes alkyles le méthyle, l'éthyle, le propyl, n-butyl, sec-butyl, isobutyl, tert-butyl, pentyl, hexyl, heptyl, octyl, 2-ethylhexyl, nonyl, decyl, undecyl, dodecyl, tridecyl, tetradecyl, pentadecyl, hexadecyl, heptadecyl, octadecyl, nonadecyl, eicosyl, hencosyl, docosyl, tricosyl, tetracosyl, pentacosyl, hexacosyl, heptacosyl, octacosyl, nonacosyl. On préfère les (méth)acrylates de méthyle, éthyle et butyle comme esters d'acide carboxylique insaturés.
- les esters vinyliques d'acide carboxyliques. A titre d'exemples d'esters vinyliques d'acide carboxylique, on peut citer l'acétate de vinyle, le versatate de vinyle, le propionate de vinyle, le butyrate de vinyle, ou le maléate de vinyle. On préfère l'acétate de vinyle comme ester vinylique d'acide carboxylique.

Avantageusement, le tronc en polyoléfine comprend au moins 50 % en moles du premier comonomère ; sa densité peut être avantageusement comprise entre 0,86 et 0,96.

Les troncs polyoléfines préférés sont constitués d'un copolymère éthylène-(méth)acrylate d'alkyle. En utilisant ce tronc polyoléfine, on obtient une excellente tenue au vieillissement à la lumière et à la température.

On ne sortirait pas du cadre de l'invention si différents « deuxièmes comonomères » étaient copolymérisés dans le tronc polyoléfine.

Selon la présente invention, le tronc polyoléfine contient au moins un reste de monomère insaturé fonctionnel (X) pouvant réagir sur une fonction acide et/ou amine du greffon polyamide par une réaction de condensation. Selon la définition de l'invention, le monomère insaturé fonctionnel (X) n'est pas un « deuxième comonomère ».

Comme monomère insaturé fonctionnel (X) compris sur le tronc polyoléfine, on peut citer :
- les époxydes insaturés. Parmi ceux-ci, ce sont par exemple les esters et éthers de glycidyle aliphatiques tels que l'allylglycidyléther, le vinylglycidyléther, le maléate et l'itaconate de glycidyle, l'acrylate et le méthacrylate de glycidyle. Ce sont aussi par exemple les esters et éthers de glycidyle alicycliques tels que le 2-cyclohexène-1-glycidyléther, le cyclohexène-4,5-diglycidylcarboxylate, le cyclohexène-4-glycidyl carboxylate, le 5-norbornène-2-méthyl-2-glycidyl carboxylate et l'endocis-bicyclo(2,2,1)-5-heptène-2,3-diglycidyl dicarboxylate. On préfère utiliser le méthacrylate de glycidyle comme époxyde insaturé.

- les acides carboxyliques insaturés et leurs sels, par exemple l'acide acrylique ou l'acide méthacrylique et les sels de ces mêmes acides.
- les anhydrides d'acide carboxylique. Ils peuvent être choisis par exemple parmi les anhydrides maléique, itaconique, citraconique, allylsuccinique, cyclohex-4-ène-1,2-dicarboxylique, 4-méthylènecyclohex-4-ène-1,2-dicarboxylique, bicyclo(2,2,1)hept-5-ène-2,3-dicarboxylique, et x-méthylbicyclo(2,2,1)hept-5-ène-2,2-dicarboxylique. On préfère utiliser l'anhydride maléique comme anhydride d'acide carboxylique.

Le monomère insaturé fonctionnel (X) est de préférence choisi parmi un anhydride d'acide carboxylique insaturé et un époxyde insaturé. En particulier, pour réaliser la condensation du greffon polyamide avec le tronc polyoléfine, dans le cas où l'extrémité réactive du greffon en polyamide est une fonction acide carboxylique, le monomère insaturé fonctionnel (X) est préférentiellement un époxyde insaturé. Dans le cas où l'extrémité réactive du greffon en polyamide est une fonction amine, le monomère insaturé fonctionnel (X) est préférentiellement un anhydride d'acide carboxylique insaturé.

Selon une version avantageuse de l'invention, le nombre préféré de monomère insaturé fonctionnel (X) fixé en moyenne sur le tronc polyoléfine est supérieur ou égal à 1,3 et/ou préférentiellement inférieur ou égal à 10.

Ainsi, si (X) est l'anhydride maléique et la masse molaire en nombre de la polyoléfine est 15 000 g/mol, on a trouvé que ceci correspondait à une proportion d'anhydride d'au moins 0,8 % en masse de l'ensemble du tronc de polyoléfine et d'au plus 6,5%. Ces valeurs associées à la masse des greffons polyamide déterminent la proportion de polyamide et de tronc dans le polymère greffé polyamide.

Le tronc polyoléfine contenant le reste du monomère insaturé fonctionnel (X) est obtenu par polymérisation des monomères (premier comonomère, deuxième comonomère éventuel, et éventuellement monomère insaturé fonctionnel (X)). On peut réaliser cette polymérisation par un procédé radicalaire à haute pression ou un procédé en solution, en réacteur autoclave ou tubulaire, ces procédés et réacteurs étant bien connus de l'homme du métier. Lorsque le monomère insaturé fonctionnel (X) n'est pas copolymérisé dans le tronc polyoléfine, il est greffé sur le tronc polyoléfine. Le greffage est également une opération connue en soi. La composition serait conforme à l'invention si plusieurs monomères fonctionnels (X) différents étaient copolymérisés et/ou greffés sur le tronc polyoléfine.

Selon les types et ratio de monomères, le tronc polyoléfine peut être semi-cristallin ou amorphe. Dans le cas des polyoléfines amorphes, seule la température de transition vitreuse est observée, tandis que dans celui des polyoléfines semi-cristallines une température de transition vitreuse et une température de fusion (qui sera nécessairement supérieure) sont observées. Il suffira à l'homme du métier de sélectionner les ratios de monomère et les masses moléculaires du tronc polyoléfine pour pouvoir obtenir pouvoir obtenir aisément les valeurs voulues de température de transition vitreuse, éventuellement de température de fusion ainsi que de viscosité du tronc polyoléfine.

De manière préférée, la polyoléfine a un Melt Flow Index (MFI) compris entre 3 et 400g/10min (190°C, 2,16kg, ASTM D 1238).

Les greffons polyamide peuvent être soit des homopolyamides, soit des copolyamides.

Sont notamment visés par l'expression "greffons polyamides" les homopolyamides aliphatiques qui résultent de la polycondensation :
- d'un lactame,
- ou d'un acide alpha,omega-aminocarboxylique aliphatique,
- ou d'une diamine aliphatique et d'un diacide aliphatique.

A titre d'exemples de lactame, on peut citer le caprolactame, l'oenantholactame et le lauryllactame.

A titre d'exemples d'acide alpha,omega-aminocarboxylique aliphatique, on peut citer l'acide aminocaproïque, l'acide amino-7-heptanoïque, l'acide amino-11-undécanoïque et l'acide amino-12-dodécanoïque.

A titre d'exemples de diamine aliphatique, on peut citer l'hexa-méthylènediamine, la dodécaméthylènediamine et la triméthylhexaméthylène diamine.

A titre d'exemples de diacide aliphatique, on peut citer les acides adipique, azélaïque, subérique, sébacique et dodécanedicarboxylique.

Parmi les homopolyamides aliphatiques, on peut citer, à titre d'exemple et de façon non limitative, les polyamides suivants : le polycaprolactame (PA6) ; le polyundécanamide (PA11, commercialisé par ARKEMA sous la marque Rilsan®) ; le polylauryllactame (PA12, également commercialisé par ARKEMA sous la marque Rilsan^{®}) ; le polybutylène adipamide (PA4.6) ; le polyhexaméthylène adipamide (PA6.6) ; le polyhexaméthylène azélamide (PA6.9) ; le polyhexaméthylène sébaçamide (PA-6.10) ; le polyhexaméthylène dodécanamide (PA6.12) ; le polydécaméthylène dodécanamide (PA10.12) ; le polydécaméthylène sébaçanamide (PA10.10) et le polydodecaméthylène dodécanamide (PA12.12).

Sont également visés par l'expression "polyamides semi-cristallins" les homopolyamides cycloaliphatiques.

On peut notamment citer les homopolyamides cycloaliphatiques qui résultent de la condensation d'une diamine cycloaliphatique et d'un diacide aliphatique.

A titre d'exemple de diamine cycloaliphatique, on peut citer la 4,4'-méthylene-bis(cyclohexylamine), encore dénommée para-bis(aminocyclo-hexyl)méthane ou PACM, la 2,2'-diméthyl-4,4'méthylène-bis(cyclo-hexyl-amine), encore dénommée bis-(3-méthyl-4-aminocyclohexyl)-méthane ou BMACM.

Ainsi, parmi les homopolyamides cycloaliphatiques, on peut citer les polyamides PACM.12, résultant de la condensation du PACM avec le diacide en C12, les BMACM.10 et BMACM.12 résultant de la condensation de la BMACM avec, respectivement, les diacides aliphatiques en C10 et en C12.

Sont également visés par l'expression "greffons polyamide" les homopolyamides semi-aromatiques qui résultent de la condensation :
- d'une diamine aliphatique et d'un diacide aromatique, tel que l'acide téréphtalique (T) et l'acide isophtalique (I). Les polyamides obtenus sont alors couramment appelés "polyphtalamides" ou PPA ;
- d'une diamine aromatique, telle que la xylylènediamine, et plus particulièrement la métaxylylènediamine (MXD) et d'un diacide aliphatique.

Ainsi, et de manière non limitative, on peut citer les polyamides 6.T, 6.I, MXD.6 ou encore MXD.10.

Les greffons polyamide rentrant enjeu dans la composition selon l'invention sont préférentiellement des copolyamides. Ceux-ci résultent de la polycondensation d'au moins deux des groupes de monomères énoncés ci-dessus pour l'obtention d'homopolyamides. Le terme « monomère » dans la présente description des copolyamides doit être pris au sens d' « unité répétitive ». En effet, le cas où une unité répétitive du PA est constituée de l'association d'un diacide avec une diamine est particulier. On considère que c'est l'association d'une diamine et d'un diacide, c'est-à-dire le couple diamine-diacide (en quantité équimolaire), qui correspond au monomère. Ceci s'explique par le fait qu'individuellement, le diacide ou la diamine n'est qu'une unité structurale, qui ne suffit pas à elle seule à polymériser pour donner un polyamide.

Ainsi, les copolyamides couvrent notamment les produits de condensation :
- d'au moins deux lactames,
- d'au moins deux acides alpha,omega-aminocarboxyliques aliphatiques,
- d'au moins un lactame et d'au moins un acide alpha,omega-aminocarboxylique aliphatique,
- d'au moins deux diamines et d'au moins deux diacides,
- d'au moins un lactame avec au moins une diamine et au moins un diacide,
- d'au moins un acide alpha,omega-aminocarboxylique aliphatique avec au moins une diamine et au moins un diacide,
la(les) diamine(s) et le(s) diacide(s) pouvant être, indépendamment l'un de l'autre, aliphatiques, cycloaliphatiques ou aromatiques.

Selon les types et ratio de monomères, les copolyamides peuvent être semi-cristallins ou amorphes. Dans le cas des copolyamides amorphes, seule la température de transition vitreuse est observée, tandis que dans celui des copolyamides semi-cristallins une température de transition vitreuse et une température de fusion (qui sera nécessairement supérieure) sont observées.

Parmi les copolyamides amorphes que l'on peut utiliser dans le cadre de l'invention, on peut citer par exemple les copolyamides contenant des monomères semi-aromatiques.

Parmi les copolyamides, on pourra également utiliser les copolyamides semi-cristallins et particulièrement ceux de type PA 6/11, PA6/12 et PA6/11/12.

Le degré de polymérisation peut varier dans de larges proportions : selon sa valeur, c'est un polyamide ou un oligomère de polyamide.

Avantageusement, les greffons polyamide sont monofonctionnels.

Pour que le greffon polyamide ait une terminaison monoamine, il suffit d'utiliser un limiteur de chaîne de formule : 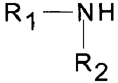 dans laquelle :
- R1 est l'hydrogène ou un groupement alkyle linéaire ou ramifié contenant jusqu'à 20 atomes de carbone,
- R2 est un groupement ayant jusqu'à 20 atomes de carbone alkyle ou alcényle linéaire ou ramifié, un radical cycloaliphatique saturé ou non, un radical aromatique ou une combinaison des précédents. Le limiteur peut être, par exemple, la butylamine, l'hexylamine, l'heptylamine, l'octylamine, la decylamine, la laurylamine ou l'oleylamine.

Pour que le greffon polyamide ait une terminaison monoacide carboxylique, il suffit d'utiliser un limiteur de chaîne de formule R'1-COOH, R'1-CO-O-CO-R'2 ou un diacide carboxylique.

R'1 et R'2 sont des groupements alkyles linéaires ou ramifiés contenant jusqu'à 20 atomes de carbone.

Avantageusement, le greffon polyamide possède une extrémité à fonctionnalité amine. Les limiteurs monofonctionnels de polymérisation préférés sont la laurylamine et l'oléylamine.

Avantageusement, les greffons polyamide ont une masse molaire comprise entre 1000 et 5000 g/mol et de préférence entre 2000 et 3000 g/mol.

La polycondensation définie ci-dessus s'effectue selon les procédés habituellement connus, par exemple à une température comprise en général entre 200 et 350°C, sous vide ou sous atmosphère inerte, avec agitation du mélange réactionnel. La longueur de chaîne moyenne du greffon est déterminée par le rapport molaire initial entre le monomère polycondensable ou le lactame et le limiteur monofonctionnel de polymérisation. Pour le calcul de la longueur de chaîne moyenne, on compte habituellement une molécule de limiteur de chaîne pour une chaîne de greffon.

Il suffira à l'homme du métier de sélectionner les types et ratio de monomères ainsi que choisir les masses molaires des greffons polyamide pour pouvoir obtenir aisément les valeurs voulues de température de transition vitreuse, éventuellement de température de fusion ainsi que de viscosité du greffon polyamide.

La réaction de condensation du greffon polyamide sur le tronc de polyoléfine contenant le reste de (X) s'effectue par réaction d'une fonction amine ou acide du greffon polyamide sur le reste de (X). Avantageusement, on utilise des greffons polyamide monoamine et on crée des liaisons amides ou imides en faisant réagir la fonction amine sur la fonction du reste de (X).

On réalise cette condensation de préférence à l'état fondu. Pour fabriquer la composition selon l'invention, on peut utiliser les techniques classiques de malaxage et/ou d'extrusion. Les composants de la composition sont ainsi mélangés pour former un compound qui pourra éventuellement être granulé en sortie de filière.

Pour obtenir les copolymères greffés de l'invention, on peut ainsi mélanger le greffon polyamide et le tronc dans une extrudeuse, par exemple double vis corotative engrenante auto nettoyante, à une température généralement comprise entre 150°C et 350°C. Le temps de séjour moyen de la matière fondue dans l'extrudeuse peut être compris entre 5 secondes et 5 minutes, et de préférence entre 20 secondes et 1 minute. Le rendement de cette réaction de condensation est évalué par extraction sélective des greffons de polyamide libres, c'est-à-dire ceux qui n'ont pas réagi pour former le polymère greffé polyamide.

La préparation de greffons polyamide à extrémité amine ainsi que leur addition sur un tronc de polyoléfine contenant le reste de (X) est décrite dans les brevets US3976720, US3963799, US5342886 et FR2291225.

Le polymère greffé polyamide de la présente invention présente avantageusement une organisation structurée à l'échelle nanométrique. Pour obtenir ce type d'organisation, on utilisera préférentiellement par exemple des greffons présentant une masse molaire en nombre Mₙ comprise entre 1000 et 5000g/mol et plus préférentiellement entre 2000 et 3000 g/mol. On utilisera également préférentiellement 10 à 50% en masse de greffons polyamide et un nombre de monomères (X) compris entre 1,3 et 10.

Avantageusement, la température d'écoulement du polymère greffé polyamide est inférieure ou égale à 160°C, ce qui permet une température de mise en oeuvre particulièrement bien adaptée aux techniques actuelles de fabrication de panneaux solaires.

S'agissant des sels métalliques de l'acide phosphonique, il peut s'agir de n'importe lequel parmi les sels métalliques de l'acide alkyl-alkyl-phosphonique de formule générale (I) :

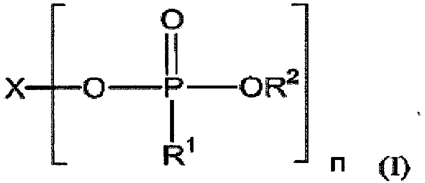

Où X est un atome métallique et R¹ et R² sont le même ou différents groupes alkyles linéaires ou branchés possédant de 1 à 12 atomes de carbone, préférentiellement de 1 à 4 atomes de carbone, tels que les exemples ci-dessous donnés de manière non limitative : méthyle, éthyle, propyle, isopropyl, butyle, isobutyle, sec-butyle ; n étant égal au degré de valence du métal X, qui se situe entre 1 et 4, de préférence entre 2 et 3. Dans la suite, relativement aux exemples de tests, on utilise l'acide méthyl-méthyl-phosphonique mais il est bien entendu qu'un résultat similaire serait obtenu avec n'importe quels sels métalliques de l'acide alkyl-alkyl-phosphonique, selon les précisions énoncées ci-dessus.

Les métaux X de la formule ci-dessus susceptibles d'être présents dans les sels métalliques de l'acide alkylalkylphosphonique comprennent les métaux alcalins ou les métaux de transition tel que le groupe ci-après donné de manière non limitative : Ca (Calcium), Mg (Magnésium), Zn (Zinc), Al (Aluminium), Fe (Fer), Ni (Nickel), Cr (Chrome), Ti (Titane).

De manière préférentielle, le sel métallique de l'acide phosphonique est le sel d'aluminium de l'acide méthyl-méthyl-phosphonique (AMMP), où X est l'atome d'aluminium, R¹ et R² sont des groupes méthyles et n est égal à 3. L'AMMP contient un taux élevé de phosphore actif (26% en poids). L'AMMP peut être synthétisé soit en faisant réagir le méthyl-méthyl-phosphonate avec une solution aqueuse de soude puis en le précipitant avec le chlorure d'aluminium, soit par la réaction directe de l'hydroxyde d'aluminium avec le méthyl-méthyl-phosphonate à 180°C sous agitation intense.

De manière préférée, le sel métallique de l'acide alkyl-alkyl-phosphonique se présente sous la forme d'une poudre avec des tailles de particules inférieures à 25 µm (micromètre), plus préférentiellement inférieures à 10 µm et encore plus préférentiellement inférieures à 5 µm. La forme préférée du sel métallique de l'acide alkyl-alkyl-phosphonique comprend une distribution de particules comprises entre 0,1 et 3 µm, sans présence de particules d'une taille inférieure à 0,1 µm.

Des charges, en particulier minérales, peuvent être ajoutées pour améliorer la tenue thermomécanique de la composition. De façon non limitative, on donnera comme exemples la silice, l'alumine ou les carbonates de calcium ou les nanotubes de carbone. Avantageusement, on utilisera des charges de taille nanométrique (argiles organophiles ou nanotubes de carbone) qui sont dispersées à l'échelle nanométrique ; ceci permettant de conserver, dans les meilleurs cas, la transparence des matériaux.

On pourra également ajouter des composés colorants ou azurants.

Concernant les aspects de l'invention relatifs à l'utilisation de la composition thermoplastique dans un module photovoltaïque, l'Homme de l'Art peut se référer par exemple au Handbook of Photovoltaic Science and Engineering, Wiley, 2003. En effet, la composition de l'invention peut être utilisée en tant qu'encapsulant ou encapsulant-backsheet dans un module photovoltaïque, dont on décrit la structure en relation avec les figures annexées.

Parmi la liste d'additifs ci-après, l'homme du métier saura aisément sélectionner leurs quantités afin d'obtenir les propriétés voulues de la composition, en particulier dans son application aux modules photovoltaïques.

Des agents de couplage, bien que non nécessaires, peuvent être avantageusement ajoutés afin d'améliorer le pouvoir d'adhérence de la composition sur les substrats de la cellule photovoltaïque lorsque celui-ci doit être particulièrement élevé. L'agent de couplage est un ingrédient non polymérique ; il peut être organique, cristallin, minéral et plus préférentiellement semi-minéral semi-organique. Parmi ceux-ci, on peut citer les titanates ou les silanes organiques, comme par exemple les monoalkyl titanates, les trichlorosilanes et les trialkoxysilanes.

Bien qu'une réticulation ne soit pas obligatoire, celle-ci est possible pour encore améliorer les propriétés thermomécaniques de l'encapsulant, en particulier lorsque la température devient très élevée. On ne sort donc pas du cadre de l'invention si des agents réticulant sont ajoutés. On peut citer comme exemple des peroxydes organiques. Cette réticulation peut également être réalisée par des techniques connues d'irradiation.

Préférentiellement, la composition ne comprend pas plus de 10% de résine tackifiante et n'en comprend préférentiellement pas. En effet, lorsque ces résines sont ajoutées au polymère greffé polyamide, la transparence de la composition et la résistance au fluage diminuent. Ces résines tackifiantes sont par exemple les colophanes et ses dérivés, les polyterpènes et ses dérivés. De manière surprenante, aucune résine tackifiante n'est nécessaire pour conférer à la composition des propriétés d'adhérence aux différents supports des modules solaires.

Dans cette application particulière de la composition aux modules photovoltaïques, le rayonnement UV étant susceptible d'entraîner un léger jaunissement de la composition utilisée en tant qu'encapsulant desdits modules, des stabilisants UV peuvent être ajoutés afin d'assurer la permanence/pérennité de la transparence de l'encapsulant durant sa durée de vie. Ces composés peuvent être par exemple à base de benzophénone ou de benzotriazole. On peut les ajouter dans des quantités inférieures à 10% en masse de la masse totale de la composition et préférentiellement de 0,1 à 5%.

### Obtention des formulations testées :

Les formulations décrites ci-dessous sont préparées par compoundage grâce par exemple à une extrudeuse double vis co-rotatives engrenant auto-nettoyante de marque COPERION® ZSK30 de diamètre 30 millimètres (mm), de longueur 44 fois son diamètre (soit 132 centimètres) avec un profil plat à 200°C avec un débit de 20 kg/h (kilogramme par heure) et une vitesse de rotation de 300 tr/min (tour par minute), les polymères et les additifs en poudre étant introduits en alimentation principale.

De manière générale, on entend par « compoundage » une technique d'obtention de polymères ou de mélanges de polymères bien connue de l'Homme de l'Art et qui consiste en une mise en forme du formulat (se présentant par exemple sous forme de joncs en sortie de malaxeur) par extrusion au travers d'une filière à trous circulaires, puis coupe des joncs refroidis et séchage pour fabriquer des granulés de quelques millimètres de diamètre et de longueur.

### Matériaux employés pour former les formulations testées :

**Apolhya^{®}** : copolymère greffé à squelette composé d'un terpolymère d'éthyléne, d'acrylate d'éthyle (AE) et d'anhydride maléique (MAh) possédant 17% d'AE, 3% de MAh et un MFI (190°C, 2.16 kg) de 70 et possédant des greffons de copolyamide mono aminé 12/6 (60/40) possédant une Mn de 2500 g/mol.
**AF069 :** sel d'aluminium de l'acide methyl-methyl-phosphonique, commercialisé par la société ICL.
**Exolit^{®} AP766 :** polyphosphate d'ammonium produit par la société CLARIANT et possédant un taux de phosphore de 21% et un taux d'azote de 12%.
**Siliporite^{®} NK10AP :** tamis moléculaire de type zéolithe 4A produit par la société CECA.
**Lotader**^{®} : Terpolymère d'éthyléne, d'acrylate d'éthyle (AE) et d'anhydride maléique (MAh) possédant 17% d'AE, 3% de MAh et un MFI (190°C, 2.16 kg) de 70.
**Domamid^{®} 24:** PA6 commercialisé par la société DOMO, possédant une viscosité relative de 2.4 mesuré à 1% dans l'acide sulfurique à 96% selon la norme ISO 307.
**Melapur^{®} C25 :** Cyanurate de mélamine commercialisé par la socité CIBA-BASF.

La présente invention est illustrée plus en détail par les exemples non limitatifs suivants.
Exemple 1 : la composition intitulée « DM1 » est une formulation entrant dans le cadre de la présente invention. Elle comprend, en pourcentage massique de la composition totale, 90,8% d'Apolhya®, 9,2% de AF069.
Exemple 2 : la composition intitulée « DM2 » est une formulation entrant dans le cadre de la présente invention. Elle comprend, en pourcentage massique de la composition totale, 98,5% d'Apolhya®, 1,5% de AF069.
Exemple 3 : la composition intitulée « DM3 » est une formulation entrant dans le cadre de la présente invention. Elle comprend, en pourcentage massique de la composition totale, 96% d'Apolhya®, 4% de AF069.
Exemple 4 : la composition intitulée « DM4 » est une formulation entrant dans le cadre de la présente invention. Elle comprend, en pourcentage massique de la composition totale, 94,3% d'Apolhya®, 5,7% de AF069.
Exemple 5 : la composition intitulée « DM5 » est une formulation entrant dans le cadre de la présente invention. Elle comprend, en pourcentage massique de la composition totale, 96,6% d'Apolhya®, 3,4% de AF069.

Pour comparer les exemples de l'invention vis-à-vis de compositions thermoplastiques de l'art antérieur, les exemples suivants de composition ont été proposés pour les tests.
Exemple 6 : la composition intitulée « DM6 » est une formulation comportant, en pourcentage massique de la composition thermoplastique, 100% d'Apolhya®.
Exemple 7 : La composition intitulée « DM7 » est une formulation comportant, en pourcentage massique de la composition thermoplastique, 78% d'Apolhya®, 20% d'Exolit® AP766 et 2% de Siliporite® NK10AP.
Exemple 8 : La composition intitulée « DM8 » est une formulation comportant, en pourcentage massique de la composition thermoplastique, 86% d'Apolhya®, 14% de AF069.
Exemple 9 : La composition intitulée « DM9 » est une formulation comportant, en pourcentage massique de la composition thermoplastique, 99,6% d'Apolhya®, 0,4% de AF069.
Exemple 10 : la composition intitulée «DM10» est une formulation comportant, en pourcentage massique de la composition thermoplastique, 6% d'AF069, 10% de Melapur MC25, 59% de Lotader et 25% de Domamid 24.

### Tests réalisés sur les éprouvettes :

Les granulés issus des procédés de synthèse sont mis en forme grâce à une extrudeuse double vis de laboratoire de type ThermoHaake Rheocord System 40 équipée d'une filière plate ; l'extrudeuse étant chauffée à 210°C pour donner des bandes à partir desquelles seront découpées, à l'emporte-pièce, les éprouvettes nécessaires afin de caractériser les matériaux.

Les tests permettant de caractériser les propriétés mécaniques d'une éprouvette standard d'une composition thermoplastique consistent, de façon la plus représentative possible, à réaliser un test de traction selon la norme ISO R527 : 93-1BA pour mesurer l'allongement et la contrainte à la rupture de ces matériaux thermoplastiques.

La valeur de l'allongement à la rupture définit la capacité d'un matériau à s'allonger avant de rompre lorsqu'il est sollicité en traction. On considère qu'un matériau présente de bonnes propriétés mécaniques du point de vue de sa ductilité/fragilité lorsque sa valeur d'allongement à la rupture est supérieure à 100% et que sa valeur de contrainte à la rupture est supérieure à 7 Mpa.

Vient ensuite le test de fluage en étuve (à chaud et sous pression supérieure à la pression atmosphérique) pendant une certaine durée. En l'occurrence, ce test de fluage des éprouvettes de type IFC (Institut Français du Caoutchouc) découpées dans les films est réalisé à 120°C sous une charge de 0,5 bar pendant 15 minutes et consiste à mesurer l'allongement subi par les éprouvettes. Si l'éprouvette cède sous la charge, on note le temps pour arriver à cette rupture. Ce test est connu de l'Homme du métier sous la dénomination anglaise de « hot set test ».

La mesure de résistance à la propagation de la flamme est ensuite effectuée selon le test UL94 selon la norme ISO 1210 sur des éprouvettes de 1,6 mm (millimètre) d'épaisseur. Ce test consiste en une double application d'une flamme normée pour déterminer les temps d'extinction d'une part et vérifier d'autre part la génération ou non de Gouttes Enflammées (GE) ou de Gouttes Non Enflammées (GNE), ce test étant répété 5 fois afin de consolider l'expérience. On notera que, pour satisfaire au classement V0 selon les tests de propagation de flamme UL 94, il est possible que des Gouttes Non Enflammées (GNE) apparaissent mais en aucun cas des Gouttes Enflammées (GE).

Dans l'application visée, le classement UL94-V2 est attendu.

On effectue ensuite les tests essentiels sur les caractéristiques de transparence de la composition thermoplastique mais également de taux de jaune et de « haze ». Tous les éprouvettes ont été soumises à des tests de mesure de la lumière transmise dans la région spectrale couvrant les longueurs d'onde comprises entre 360 nm et 830 nm et on a mesuré le pourcentage de cette lumière transmise pour chacune des éprouvettes selon la norme ASTM D1003.

Dans l'application visée, un pourcentage de transmission de la lumière visible, typiquement dans un domaine de 400 à 800 nm de longueur d'onde, le plus élevé possible et d'au moins 85% est attendu/souhaité.

Ce test est complété par la mesure du « taux de jaune » qui mesure, après un certain délai et sous un environnement particulier, le taux de jaunissement de l'éprouvette.

Dans l'application visée, un indice de jaune le plus bas possible, inférieur à 5 et de préférence inférieur à 2 est attendu/souhaité.

Le test de Haze consiste à mesurer la lumière transmise au travers d'une éprouvette. Cette lumière transmise est mesurée grâce à un néphélomètre ou un spectrophotomètre. Le niveau de trouble ou Haze est mesuré selon la norme ASTM D1003 avec un illuminant C sous 2°.

Dans l'application visée, un taux de Haze le plus bas possible, inférieur à 10 et de préférence inférieur à 5 est attendu/souhaité.

Tous ces tests sont réalisés de façon classique en prenant des éprouvettes standards de forme identique pour chaque composition testée et en leur faisant subir chaque test sur banc d'essai, selon les définitions (forme, dimensions, vitesses d'essai, étalonnage de la machine, exactitude des appareils etc.) données par les normes internationales et bien connues de l'homme du métier.

La composition doit satisfaire l'ensemble des tests susvisés de manière optimum pour être considérée comme satisfaisante du point de vue de ses propriétés mécaniques (allongement et contrainte à la rupture), de ses propriétés thermomécaniques ou autrement dit de sa résistance au fluage à température élevée (fluage à chaud), de ses propriétés ignifuges (classement UL94) et enfin au regard de sa transparence. Il est bien entendu que la difficulté consiste à trouver une composition présentant de bonnes performances pour l'ensemble des propriétés testées et qu'une seule de ces propriétés à un niveau inférieur à l'exigence de l'application suffit à disqualifier cette composition.

Comme on peut le constater, la demanderesse a constaté, après ses expérimentations, que, de façon surprenante, la composition selon l'invention a parfaitement satisfait l'ensemble des tests démontrant, que ses propriétés mécaniques, thermomécaniques et ignifuges sont excellentes, ou autrement dit d'un niveau très élevé.

Les compositions selon l'invention remplissent donc les critères pour pouvoir être très avantageusement utilisée comme liant ou encapsulant ignifugé dans les modules solaires.

### Résultats des tests réalisés sur les éprouvettes des différentes formulations :

| | **DM1** | **DM2** | **DM3** | **DM4** | **DM5** | **DM6** | **DM7** | **DM8** | **DM9** | **DM10** |
|---|---|---|---|---|---|---|---|---|---|---|
| APOLHYA | 90,8 | 98,5 | 96 | 94,3 | 96,6 | 100 | 78 | 86 | 99,6 | |
| AF069 | 9,2 | 1,5 | 4 | 5,7 | 3,4 | | | 14 | 0,4 | 6 |
| Exolit AP766 | | | | | | | 20 | | | |
| Siliporite NK10AP | | | | | | | 2 | | | |
| Melapur MC25 | | | | | | | | | | 10 |
| Lotader | | | | | | | | | | 59 |
| Domamid 24 | | | | | | | | | | 25 |

| **ESSAIS / TESTS** | | | | | | | | | | |
|---|---|---|---|---|---|---|---|---|---|---|
| Allongement Rupture (%) | 290 | 420 | 439 | 380 | 430 | 436 | 252 | 300 | 410 | 42 |
| Contrainte Rupture (Mpa) | 9.8 | 12 | 11,9 | 11.6 | 12.1 | 12,3 | 6 | 9 | 11.9 | 4 |
| Fluage à chaud (% ou temps) | 11% | 18% | 17% | 15% | 19% | 20% | 10% | 14% | 20% | 5 min |
| Classement UL94 | V2 | V2/NC | V2 | V2 | V2 | NC* | V0 | V2 | NC* | V0 |
| Transmission de lumière (%) | 85.2 | 86.4 | 86,1 | 85.8 | 86.2 | 86,6 | 20 | 74 | 86.4 | 15 |
| Taux de jaune (%) | 3.9 | 3.3 | 3,4 | 3.4 | 3.2 | 3,2 | 6 | 8 | 3 | 9 |
| Haze (%) | 8 | 3 | 6 | 7 | 6 | 2 | 100 | 18 | 2 | 100 |

| | | | | | | | | | | |
|---|---|---|---|---|---|---|---|---|---|---|
| *: NC = non classé | | | | | | | | | | |

En réalisant ces premières expérimentations, la demanderesse avait noté que l'ajout d'AF069 était particulièrement préjudiciable à la transparence de polymère initialement transparent ou semi-transparent. Ci-dessous sont présentés un tableau de résultats avec le polymère PC Makrolon, du Rilsan G830, de l'Altuglas V825T modifié ou de l'Apolhya Solar.

| Transmittance sur films (illuminant D65 angle 2°) | **Apolhya LC3** | | **Makrolon 2207** | | **Rilsan G830** | | **Altuglas V825T** | |
|---|---|---|---|---|---|---|---|---|
| | Pur | +4% AF069 | Pur | +4% AF069 | Pur | +4% AF069 | Pur | +4% AF069 |
| Epaisseur (µm) | 600 | 550 | 60 | 60 | 50 | 90 | 160 | 130 |
| Transmittance à 560 nm | 89,9 | 87,5 (-3%) | 90,1 | 82,7 (-8%) | 91,6 | 85,3 (-7%) | 89,9 | 86,6 (-4%) |
| Taux de jaune (YI) (*selon ASTME313 D65*) | 1,7 | 3 (x 1,7) | 0,5 | 1,6 (x 3) | 0,4 | 2,4 (x 6,2) | 0,9 | 2,4 (x 2,6) |
| Haze (*selon ASTM D1003-97 C*) | 8 | 15 (x 1,9) | 1 | 40 (x 40) | 1 | 20 (x 20) | 7 | 19 (x 2,9) |

Les produits utilisés pour réaliser les études et les analyses ci-dessous sont les suivants :
Apolhya^{®} LC3 : Thermoplastique à base de copolymère nanostructuré possédant une température de fusion de 130°C et une valeur de MFI de 15 à 20 g/10 min selon ASTM D1238 à 190°C sous 2.16 kg produit et commercialisé par ARKEMA
Makrolon^{®} 2207 : Polycarbonate de basse viscosité possédant une valeur de MFI de 38 selon ASTM D1238 à 300°C sous 1.2 kg produit et commercialisé par la société Bayer
Rilsan^{®} G830 : Polyamide transparent bio-ressoucré possédant une température de transition vitreuse de 135°C, un taux de carbone renouvelable de 53 à 55% produit et commercialisé par la société ARKEMA
Altuglas^{®} V825T : PMMA possédant une valeur de MFI de 3.8 selon ASTM D1238 sous 3.8 kg à 230°C et une température de ramolissement Vicat de 101°C selon ASTM D1525 produit et commercialisé par la société Altuglass.

Ces résultats montrent que l'ajout de d'une quantité significative d'AF069 (4%) réduit considérablement les propriétés optiques des matériaux polymères. En particulier, ceci est vrai pour le Makrolon 2207 et pour le Rilsan G830 et dans une moindre mesure, mais également de façon notable, pour l'Altuglas V825T et l'Apolhya LC3.

Il est donc évident que l'homme du métier, au regard de ces premières résultats, ne pouvait envisager que l'addition d'AF069 pouvait être envisageable pour améliorer les propriétés des matériaux polymères transparents, sans altérer fortement leurs propriétés de transparence (transmittance, taux de jaune et Haze) et ce n'est qu'après un grand nombre d'expériences que la demanderesse est arrivé à un résultat optimum, dans la gamme d'AF069 particulière ajouté à la composition thermoplastique de base.

## Revendications

1. Composition thermoplastique ignifugée et transparente ne contenant pas de composé halogéné, comprenant un copolymère greffé à blocs polyamides constitué d'un tronc en polyoléfine et d'en moyenne au moins un greffon en polyamide dans lequel les greffons sont attachés au tronc par les restes d'un monomère insaturé fonctionnel (X) ayant une fonction capable de réagir avec un polyamide, les restes du monomère insaturé (X) sont fixés sur le tronc par greffage ou copolymérisation depuis sa double liaison, ledit polymère greffé polyamide présentant une organisation structurée à l'échelle nanométrique, **caractérisée en ce qu'**elle comprend, en pourcentage massique de la composition totale :
- entre 90% et 99% en poids du copolymère greffé à blocs polyamides,
- entre 1% et 10% en poids en sel métallique de l'acide phosphonique.

2. Composition selon la revendication 1, **caractérisée en ce qu'**elle comprend :
- entre 94% et 97% en poids du copolymère greffé à blocs polyamides,
- entre 3% et 6% en poids en sel métallique de l'acide alkyl alkylphosphonique.

3. Composition selon la revendication 1 ou 2, **caractérisée en ce que** le copolymère greffé à blocs polyamide comprend de 10% à 50% en masse de greffons en polyamide.

4. Composition selon l'une quelconque des revendications précédentes, **caractérisée en ce que** la masse molaire des greffons polyamide est comprise dans la gamme allant de 1000 à 5000g/mol, de préférence comprise dans la gamme allant de 2000 à 3000 g.mol⁻¹.

5. Composition selon l'une quelconque des revendications précédentes, **caractérisée en ce que** le nombre de monomère (X) fixé sur le tronc polyoléfine est supérieur ou égal à 1,3 et/ou inférieur ou égal à 10.

6. Composition selon l'une des revendications précédentes, **caractérisée en ce que** le monomère insaturé (X) est choisi parmi un anhydride d'acide carboxylique et un époxyde insaturé.

7. Composition selon l'une des revendications précédentes, **caractérisée en ce qu'**elle comprend uniquement le copolymère greffé à blocs polyamides et un sel métallique de l'acide alkyl alkylphosphonique.

8. Composition selon l'une des revendications 1 à 6, **caractérisée en ce que** ladite composition comprend, en outre, au moins un agent de couplage.

9. Utilisation de la composition selon l'une quelconque des revendications précédentes en tant que film encapsulant pour un module photovoltaïque (20).

10. Module photovoltaïque (20) présentant au moins deux films dont au moins un film formant encapsulant (22, 23) comportant une pile photovoltaïque (10) apte à générer de l'énergie électrique, ce film (22, 23) étant formé par la susdite composition thermoplastique selon l'une quelconque des revendications 1 à 8.

## Patentansprüche

1. Flammgeschützte und transparente thermoplastische Zusammensetzung, die keine halogenierte Verbindung enthält, umfassend ein Pfropfcopolymer mit Polyamidblöcken, bestehend aus einer Polyolefin-Hauptkette und durchschnittlich mindestens einem Polyamid-Pfropfanteil, worin die Pfropfanteile über die Reste eines funktionellen ungesättigten Monomers (X) mit einer Funktion, die mit einem Polyamid reagieren kann, an die Hauptkette gebunden sind, die Reste des ungesättigten Monomers (X) durch Pfropfung oder Copolymerisation über seine Doppelbindung an der Hauptkette fixiert sind, wobei das Polyamid-Pfropfpolymer eine nanostrukturierte Organisation aufweist, **dadurch gekennzeichnet, dass** sie in Gewichtsprozent der gesamten Zusammensetzung:
- zwischen 90 und 99 Gew.-% des Pfropfcopolymers mit Polyamidblöcken und
- zwischen 1 und 10 Gew.-% eines Metallsalzes von Phosphonsäure
umfasst.

2. Zusammensetzung nach Anspruch 1, **dadurch gekennzeichnet, dass** sie:
- zwischen 94 und 97 Gew.-% des Pfropfcopolymers mit Polyamidblöcken und
- zwischen 3 und 6 Gew.-% eines Metallsalzes von Alkylalkylphosphonsäure
umfasst.

3. Zusammensetzung nach Anspruch 1 oder 2, **dadurch gekennzeichnet, dass** das Pfropfcopolymer mit Polyamidblöcken 10 bis 50 Gew.-% Polyamid-Pfropfanteile umfasst.

4. Zusammensetzung nach einem der vorhergehenden Ansprüche, **dadurch gekennzeichnet, dass** die Molmasse der Polyamid-Pfropfanteile im Bereich von 1000 bis 5000 g/mol und vorzugsweise im Bereich von 2000 bis 3000 g.mol⁻¹ liegt.

5. Zusammensetzung nach einem der vorhergehenden Ansprüche, **dadurch gekennzeichnet, dass** die Zahl der an der Polyolefin-Hauptkette fixierten Monomere (X) größer gleich 1,3 und/oder kleiner gleich 10 ist.

6. Zusammensetzung nach einem der vorhergehenden Ansprüche, **dadurch gekennzeichnet, dass** das ungesättigte Monomer (X) aus einem Carbonsäureanhydrid und einem ungesättigten Epoxid ausgewählt ist.

7. Zusammensetzung nach einem der vorhergehenden Ansprüche, **dadurch gekennzeichnet, dass** sie nur das Pfropfcopolymer mit Polyamidblöcken und ein Metallsalz von Alkylalkylphosphonsäure umfasst.

8. Zusammensetzung nach einem der Ansprüche 1 bis 6, **dadurch gekennzeichnet, dass** die Zusammensetzung außerdem mindestens ein Kupplungsmittel umfasst.

9. Verwendung der Zusammensetzung nach einem der vorhergehenden Ansprüche als Verkapselungsfilm für ein Photovoltaikmodul (20).

10. Photovoltaikmodul (20) mit mindestens zwei Filmen, wobei mindestens ein ein Verkapselungsmittel bildender Film (22, 23) eine zur Erzeugung von elektrischer Energie befähigte Photovoltaikzelle (10) umfasst, wobei der Film (22, 23) durch obige thermoplastische Zusammensetzung nach einem der Ansprüche 1 bis 8 gebildet wird.

## Claims

1. A flame-retardant and transparent thermoplastic composition that contains no halogenated compound, comprising a polyamide-block graft copolymer consisting of a polyolefin backbone and, on average, at least one polyamide graft wherein the grafts are attached to the backbone by the residues of a functional unsaturated monomer (X) having a function capable of reacting with a polyamide, the residues of the unsaturated monomer (X) are attached to the backbone by grafting or copolymerization via its double bond, said polyamide-block graft composition presenting a nanostructured organization,**characterized in that** it comprises, as a weight percentage of the total composition:
- between 90% and 99% by weight of the polyamide-block graft copolymer, and
- between 1% and 10% by weight of a metal salt of phosphonic acid.

2. The composition as claimed in claim 1, **characterized in that** it comprises:
- between 94% and 97% by weight of the polyamide-block graft copolymer, and
- between 3% and 6% by weight of a metal salt of alkyl alkylphosphonic acid.

3. The composition as claimed in claim 1 or 2, **characterized in that** the polyamide-block graft copolymer comprises from 10% to 50% by weight of polyamide grafts.

4. The composition as claimed in any one of the preceding claims, **characterized in that** the molar mass of the polyamide grafts is within the range extending from 1000 to 5000 g/mol, preferably within the range extending from 2000 to 3000 g.mol⁻¹.

5. The composition as claimed in any one of the preceding claims, **characterized in that** the number of monomers (X) attached to the polyolefin backbone is greater than or equal to 1.3 and/or less than or equal to 10.

6. The composition as claimed in one of the preceding claims, **characterized in that** the unsaturated monomer (X) is chosen from a carboxylic acid anhydride and an unsaturated epoxide.

7. The composition as claimed in one of the preceding claims, **characterized in that** it comprises only the polyamide-block graft copolymer and a metal salt of alkyl alkylphosphonic acid.

8. The composition as claimed in one of claims 1 to 6, **characterized in that** said composition comprises, in addition, at least one coupling agent.

9. The use of the composition as claimed in any one of the preceding claims as an encapsulant film for a photovoltaic module (20).

10. A photovoltaic module (20) having at least two films, including at least one film that forms an encapsulant (22, 23), comprising a photovoltaic cell (10) capable of generating electrical energy, this film (22, 23) being formed by the aforesaid thermoplastic composition as claimed in any one of claims 1 to 8.
